# EUROPEAN PATENT APPLICATION

(11) **EP 0 647 016 A1**
(43) Date of publication of application: **05.04.1995**
(21) Application number: 94306737.1
(22) Date of filing: 14.09.1994
(51) Int. Cl.: H03D 7/16, H04B 1/30

(54) **Direct conversion receivers**

(30) Priority: 30.09.1993 GB 9320146
(71) Applicant: PLESSEY SEMICONDUCTORS LIMITED, Swindon, Wiltshire SN2 2QW (GB)
(72) Inventor: Mapleston, David Bernard, Highworth, Wiltshire SK6 7DR (GB)
(74) Representative: Hoste, Colin Francis

(57) **Abstract**

A radio receiver arrangement utilising direct conversion or conversion to a low IF frequency, in which the local oscillator signal is frequency modulated to avoid the possibility of the local oscillator frequency drifting into a zero beat frequency region where only a d.c. voltage will be obtained from the mixer.

## Description

The present invention relates to direct conversion or homodyne radio receivers. Such receivers have a number of advantages over conventional heterodyne receivers, among which are that expensive image signal filtering is not required, selectivity filters are at low frequency, so that op-amp filters or gyrator filters may be used and, since image frequency signals are not filtered out, a sensitivity improvement of 3dB over conventional heterodyne receivers can be obtained.

However, a major concern in direct conversion receivers is the possibility of the local oscillator drifting in frequency into the zero frequency beat region, where only a d.c. voltage will he obtained from the mixer.

According to one aspect of the present invention in a direct conversion radio receiver or a low IF radio receiver the local oscillator is arranged to be frequency modulated.

According to another aspect of the present invention in a radio receiver for receiving carrier frequency signals which are amplitude modulated with audio frequency or low frequency signals, and in which a local oscillator is arranged to provide signals of a frequency substantially at or close to said carrier frequency to enable direct conversion of received signals or conversion to a low IF, the local oscillator is arranged to be frequency modulated.

Preferably the modulation frequency and the frequency deviation of the local oscillator signals are above the maximum expected data rate or audio frequency at the output of the mixer of the receiver.

A radio receiver in accordance with the present invention will now be described with reference to the accompanying drawing, of which:-
Figure 1 shows the receiver schematically, and
Figure 2 illustrates the frequency range of signals occurring in the receiver of Figure 1.

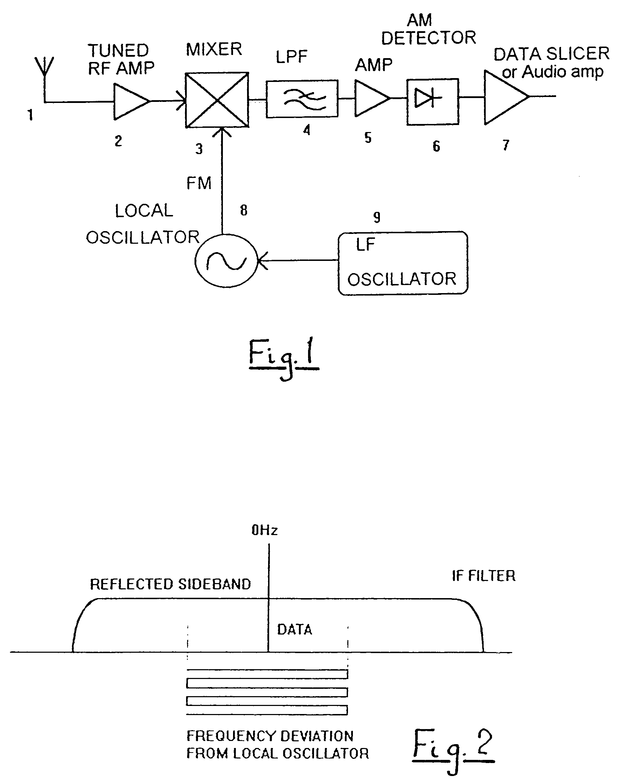

Referring to Figure 1, as in a conventional receiver an amplitude modulated carrier signal at a nominal frequency of, say 433 MHz is received at antenna 1, amplified by an RF amplifier 2 and applied to a mixer 3. The output signals from the mixer 3 may be low-pass filtered by filter 4, amplified by amplifier 5, rectified by detector 6 and applied either to a data slicer or to an audio amplifier 7.

In the present arrangement a local oscillator 8, which provides signals to the mixer 3 at the same nominal frequency as the received signals, is frequency modulated by signals from a low frequency oscillator 9, which a frequency deviation of, say, 80kHz. The signals from the oscillator 9 may be square wave signals at a frequency of 40 kHz, as indicated in Figure 2, so that the frequency modulated local oscillator signals to the mixer 3 effectively sample the received amplitude modulated signals at two different low IF frequencies. If the frequency of the carrier signal or of the local oscillator 8 drifts one or other of these two IF signals remains within the passband of the filter 4 over twice the range of frequency drift tolerable with a conventional unmodulated local oscillator.

The frequencies introduced by the frequency modulation of the local oscillator 8 are filtered out at the detector stage 6, which may, for example, be a logarithmic detector.

## Claims

1. A direct conversion radio receiver or a low IF radio receiver wherein the local oscillator is arranged to be frequency modulated.

2. A radio receiver for receiving carrier frequency signals which are amplitude modulated with audio frequency or low frequency signals, and in which a local oscillator is arranged to provide signals of a frequency substantially at or close to said carrier frequency to enable direct conversion of received signals or conversion to a low IF, wherein the local oscillator is arranged to be frequency modulated.

3. A radio receiver in accordance with Claim 1 or Claim 2 wherein the modulation frequency and the frequency deviation of the local oscillator signals are above the maximum expected data rate or audio frequency at the output of the mixer of the receiver.
